# EUROPEAN PATENT APPLICATION

(11) **EP 4 516 832 A1**
(43) Date of publication of application: **05.03.2025**
(21) Application number: 23796585.0
(22) Date of filing: 15.02.2023
(51) Int. Cl.: C08G 59/32, C08G 59/34, C08G 59/42, C08L 63/00, C08K 3/013, C09K 11/00, G02F 1/017

(54) **SOLVENT-FREE THERMOSETTING QUANTUM DOT RESIN COMPOSITION, QUANTUM DOT RESIN COMPOSITE PREPARED THEREFROM, AND LED PACKAGE AND DISPLAY DEVICE EMPLOYING SAME**

(30) Priority: 25.04.2022 KR 20220050837
(71) Applicant: Hansol Chemical Co., Ltd., Gangnam-gu Seoul 06169 (KR)
(72) Inventor: NOH, Jae Hong, Wanju-gun, Jeollabuk-do 55321 (KR); SEO, Min Kyung, Wanju-gun, Jeollabuk-do 55321 (KR); YOON, Gyu Cheol, Wanju-gun, Jeollabuk-do 55321 (KR); JEONG, Sang Gil, Wanju-gun, Jeollabuk-do 55321 (KR); KIM, Kyung Nam, Wanju-gun, Jeollabuk-do 55321 (KR); HA, Sung Min, Wanju-gun, Jeollabuk-do 55321 (KR); NAM, Chun Rae, Wanju-gun, Jeollabuk-do 55321 (KR)
(74) Representative: Cabinet Beau de Loménie
(86) International application number: PCT/KR2023/002183
(87) International publication number: WO 2023/210935

(57) **Abstract**

The present invention relates to a solvent-free thermosetting quantum dot resin composition, a quantum dot resin composite prepared therefrom, an LED package and a display device employing the same and, specifically, to a solvent-free thermosetting quantum dot resin composition having excellent ability to maintain optical characteristics even after long-term driving of a display, a quantum dot resin composite prepared therefrom, an LED package and a display device employing same.

## Description

### [Technical Field]

The present invention relates to a solvent-free thermosetting quantum dot resin composition, a quantum dot resin composite prepared therefrom, an LED package and a display device employing the same, and more particularly to a solvent-free thermosetting quantum dot resin composition, which can secure good retention of optical properties even after long-term driving of a display, a quantum dot resin composite prepared therefrom, an LED package and a display device employing the same.

### [Background Art]

In general, quantum dots (QDs), also known as semiconductor nanocrystals, are attracting attention as next generation light emitting elements, since the quantum dots can emit various colors through generation of light with different wavelengths depending on particle size without changing the kind of substance and have advantages of better color purity and photo-stability than typical light emitting materials.

Currently, in commercially available displays using quantum dots, a film containing quantum dots (QDs) is embedded in a TV. The use of the quantum dots in a film form has a disadvantage of increasing the use amount of the quantum dots. Application of the quantum dots in the film form to an LED package display can provide significant reduction not only in quantity of quantum dots used, but also in thickness of the TV while ensuring self-emissive characteristics, as in OLED TVs.

However, an LED package display has a problem of large thermal resistance, causing deterioration in lifespan and reliability. In this regard, a technique for improving color gamut and durability using organic compounds and inorganic phosphors instead of quantum dots vulnerable to heat and moisture (Korean Patent Laid-open Publication No. 10-2018-0061146), and a technique for improving thermal stability of quantum dots by synthesizing quantum dots having a continuous crystal growth structure and forming a metal oxide film on the surface of the quantum dots (Korean Patent Laid-open Publication No. 10-2018-0097201) are disclosed in the art.

However, it is difficult to solve these problems simply through improvement in heat resistance and there is a need for durable and reliable quantum dot resin compositions or quantum dot composites in order to apply quantum dots to LED package displays.

### [Disclosure]

### [Technical Problem]

With the development of high-power LEDs, a thermosetting resin having better heat resistance and light resistance has been more commonly used as an encapsulation material for protecting LED chip among thermoplastic resins or thermosetting resins that have been used in the art.

Typically, although an alicyclic epoxy resin or polysiloxane has been used as such a thermosetting resin, it is found that, when an LED package display is used for a long period of time, there occurs a problem of deterioration in optical properties, such as luminance and chromaticity, or change in chromaticity. Moreover, the use of isocyanurate or nano-silica materials to improve heat resistance of the alicyclic epoxy fails to solve the problem of deterioration in optical properties.

Therefore, it is an object of the present invention to provide a solvent-free thermosetting quantum dot resin composition with improved light stability and reliability, a quantum dot resin composite prepared therefrom, and an LED package and display device employing the same.

### [Technical Solution]

In accordance with one aspect of the present invention, there is provided a solvent-free thermosetting quantum dot resin composition comprising: quantum dots; an epoxy resin; an acid anhydride curing agent; and a curing accelerator,
wherein the epoxy resin comprises a dicyclopentadiene type epoxy resin.

Preferably, the epoxy resin further comprises a triglycidyl isocyanurate.

Preferably, the dicyclopentadiene type epoxy resin contains a (meth)acrylate functional group.

Preferably, the epoxy resin and the acid anhydride curing agent are comprised in a weight ratio of 1:0.5 to 1:1.4.

Preferably, the solvent-free thermosetting quantum dot resin composition has an optical property retention rate of 80% or more, as calculated by Equation 1.[Equation 1] Optical property retention rate (%) = (Optical properties of display after operation for 1,000 hours / Optical properties of display before operation) X 100

Preferably, the solvent-free thermosetting quantum dot resin composition comprises: 1 part by weight to 30 parts by weight of the quantum dots;
1 part by weight to 50 parts by weight of the epoxy resin;
1 part by weight to 50 parts by weight of the acid anhydride curing agent; and
0.05 parts by weight to 1 part by weight of the curing accelerator.

Preferably, the epoxy resin further comprises
at least one selected from the group consisting of an alicyclic epoxy resin, a BPA-PO epoxy resin, a bisphenol A type resin, a bisphenol F type epoxy resin, a novolac type epoxy resin, a nitrogen-containing epoxy resin, a linear aliphatic epoxy resin, and a naphthalene type epoxy resin.

Preferably, the acid anhydride curing agent comprises
at least one selected from the group consisting of phthalic anhydride, maleic anhydride, trimellitic anhydride, hexahydrophthalic anhydride, tetrahydrophthalic anhydride, methyl nadic anhydride, nadic anhydride, glutaric anhydride, dimethyl glutaric anhydride, diethyl glutaric anhydride, methyl hexahydrophthalic anhydride, and methyl tetrahydrophthalic anhydride.

Preferably, the curing accelerator comprises
at least one from the group consisting of tertiary amines, imidazole compounds, quaternary phosphonium salts, organometallic salts, and phosphorus compounds.

Preferably, the solvent-free thermosetting quantum dot resin composition further comprises inorganic fillers,
the inorganic fillers comprising at least one selected from the group consisting of silica, zinc oxide, alumina, calcium carbonate, barium carbonate, barium sulfate, zinc sulfate, zinc sulfide, magnesium oxide, and antimony oxide.

In accordance with another aspect of the present invention, there is provided a quantum dot resin composite prepared by the solvent-free thermosetting quantum dot resin composition.

In accordance with a further aspect of the present invention, there is provided an LED package including: an LED chip; and
a photo-conversion layer formed on the LED chip and prepared by the solvent-free thermosetting quantum dot resin composition.

In accordance with yet another aspect of the present invention, there is provided a display device including the LED package.

### [Advantageous Effects]

The solvent-free thermosetting quantum dot resin composition according to the present invention and the quantum dot resin composite prepared therefrom have good durability, and exhibit good retention of optical properties even after use for a long period of time, when applied to LED packages and display devices.

In addition, the solvent-free thermosetting quantum dot resin composition according to the present invention has good miscibility between quantum dots and a resin even without a solvent and can realize various viscosities, thereby enabling manufacture of a display device under various process conditions.

### [Best Mode]

Hereinafter, exemplary embodiments of the present invention will be described in detail.

Unless otherwise defined herein, all terms (including technical and scientific terms) used herein have the same meaning as commonly understood by one of ordinary skill in the art to which this disclosure pertains. Terms, such as those defined in commonly used dictionaries, should be interpreted as having a meaning that is consistent with their meaning in the context of the related art and should not be interpreted in an idealized or overly formal sense, unless clearly defined herein.

In addition, as used herein, the terms "comprises," "comprising," "includes," and/or "including" mean that, unless specifically stated to the contrary, it does not exclude other components but may further comprise other components.

Herein, optical properties include luminance (Lv) and chromaticity (Cx, Cy) of a display.

### <Solvent-free thermosetting quantum dot resin composition>

A quantum dot resin composition according to one embodiment of the present invention is a solvent-free thermosetting quantum dot resin composition. Specifically, the quantum dot resin composition has good miscibility between quantum dots and a resin even without a solvent and can realize various viscosities, thereby enabling manufacture of a display device under various process conditions.

In one embodiment, the solvent-free thermosetting quantum dot resin composition includes quantum dots, an epoxy resin, an acid anhydride curing agent, and a curing accelerator, wherein the epoxy resin includes a dicyclopentadiene (DCPD) type epoxy resin.

The dicyclopentadiene type epoxy resin secures high durability and good retention of optical properties even after use for a long period of time. In addition, the epoxy resin may further include triglycidyl isocyanurate in addition to the dicyclopentadiene type epoxy resin, whereby the solvent-free thermosetting quantum dot resin composition can obtain the effect of maintaining optical properties after use for a long period of time.

Preferably, the dicyclopentadiene type epoxy resin further contains a (meth)acrylate functional group to provide high adhesion and good barrier properties (moisture resistance) to the solvent-free thermosetting quantum dot resin composition, whereby the solvent-free thermosetting quantum dot resin composition can have better durability and can maintain the optical properties even after use for a long period of time. In addition, the solvent-free thermosetting quantum dot resin composition can have low viscosity properties, thereby enabling even dispersion of the quantum dots without a solvent while realizing various viscosities.

The quantum dot resin composition according to one embodiment may further include inorganic fillers to impart thixotropy.

The quantum dot resin composition according to one embodiment of the invention may include 1 part by weight to 30 parts by weight of the quantum dots, 1 part by weight to 50 parts by weight of the epoxy resin, 1 part by weight to 50 parts by weight of the acid anhydride curing agent, and 0.05 parts by weight to 1 part by weight of the curing accelerator.

The quantum dot resin composition according to one embodiment of the invention may include 1 part by weight to 30 parts by weight of the quantum dots, 1 part by weight to 50 parts by weight of the epoxy resin, 1 part by weight to 50 parts by weight of the acid anhydride curing agent, 0.05 parts by weight to 1 part by weight of the curing accelerator, and 0.1 parts by weight to 20 parts by weight of the inorganic fillers.

Hereinafter, each component of the solvent-free thermosetting quantum dot resin composition of the present invention will be described in detail.

### Epoxy resin

In the present invention, the epoxy resin preferably includes a dicyclopentadiene (DCPD) type epoxy resin and may further include triglycidyl isocyanurate (TGIC). The dicyclopentadiene (DCPD) type epoxy resin may include a (meth)acrylate functional group. Here, "(meth)acrylate" refers to acrylate and methacrylate.

The DCPD type epoxy resin refers to an epoxy resin derived from dicyclopentadiene and having at least two epoxy groups per molecule.

When the DCPD type epoxy resin is included, the solvent-free thermosetting quantum dot resin composition exhibits good adhesion and good barrier properties to prevent external air and moisture from penetrating into the quantum dot resin composition, thereby improving durability and the optical property retention rate of the quantum dot resin composition. Furthermore, a DCPD type epoxy resin containing at least one (meth)acrylate functional group can further improve adhesion and barrier properties of the quantum dot resin composition, thereby significantly improving the optical property retention rate thereof. It be believed that this result is due to a more complex and dense three-dimensional network structure formed through curing by the (meth)acrylate functional group in addition to curing between the epoxy group and the curing agent.

The triglycidyl isocyanurate (TGIC) can be cured in three directions and thus can secure high mechanical strength and heat resistance as well as good adhesion and high temperature performance. Thus, it is believed that, when used together with the DCPD type epoxy resin, the triglycidyl isocyanurate assists in improvement in adhesion and barrier properties of the quantum dot resin composition, thereby improving the optical property retention rate thereof. Although not listed as a comparative example in the specification, the TGIC epoxy also provides better light stability than a bisphenol A type epoxy resin or an alicyclic epoxy resin, when applied to the DCPD type epoxy resin.

In addition, depending on properties, such as heat resistance, chemical resistance, and the like, the epoxy resin may further include at least one selected from the group consisting of an alicyclic epoxy resin, a BPA-PO epoxy resin, a bisphenol A type epoxy resin, a bisphenol F type epoxy resin, a novolac type epoxy resin, a nitrogen-containing epoxy resin, a linear aliphatic epoxy resin, and a naphthalene type epoxy resin. For example, the bisphenol A type epoxy resin, the bisphenol F type epoxy resin, or the novolac type epoxy resin may be added to enhance chemical resistance and heat resistance, and the alicyclic epoxy resin may be added to enhance weather resistance and tracking resistance. The BPA-PO epoxy resin may be used to achieve flexibility of a cured product, the linear aliphatic epoxy resin may be used to improve workability by realizing low viscosity, and the naphthalene type epoxy resin may be used for low thermal expansion and moisture resistance.

In the quantum dot resin composition, the epoxy resin may be present in a total amount of 1 part by weight to 50 parts by weight, preferably 20 parts by weight to 50 parts by weight, more preferably 35 parts by weight to 45 parts by weight. If the content of the epoxy resin is less than 1 part by weight, a cured product of the resin composition can suffer from deterioration in mechanical properties, and if the content of the epoxy resin exceeds 50 parts by weight, a display device can suffer from deterioration in optical properties.

The epoxy resin and the acid anhydride curing agent may be comprised in a weight ratio of 1:0.5 to 1:1.4, preferably 1:0.75 to 1:1.2, more preferably 1:0.9 to 1:1.0. When the epoxy resin and the acid anhydride curing agent are present in the above weight ratio, the quantum dot resin composition can achieve improvement in optical property retention rate, particularly significant improvement in luminance (Lv) retention rate.

### Acid anhydride curing agent

In the present invention, the acid anhydride curing agent reacts with the epoxy resin to form a three-dimensional network structure, thereby improving mechanical properties of a cured product of the composition. Just as the nature of the epoxy resin affect the properties of the composition and a final cured product thereof, the nature of the curing agent also affects the properties of the composition and the final cured product, and the use of the anhydride curing agent instead of an amine-based curing agent, such as an aliphatic diamine, a polyamine, and an aromatic diamine, secures good heat resistance of the quantum dot resin composition.

In the present invention, the acid anhydride curing agent may include at least one selected from the group consisting of phthalic anhydride, maleic anhydride, trimellitic anhydride, hexahydrophthalic anhydride, tetrahydrophthalic anhydride, methyl nadic anhydride, nadic anhydride, glutaric anhydride, dimethyl glutaric anhydride, diethyl glutaric anhydride, methyl hexahydrophthalic anhydride, and methyl tetrahydrophthalic anhydride.

In the quantum dot resin composition, the acid anhydride curing agent may be present in an amount of 1 part by weight to 50 parts by weight, preferably 20 parts by weight to 50 parts by weight, more preferably 35 parts by weight to 45 parts by weight. If the content of the acid anhydride curing agent is less than 1 part by weight, curing of the epoxy resin can be delayed or can be insufficient, and if the content of the acid anhydride curing agent exceeds 50 parts by weight, there is no benefit from the excess content and the optical properties of the display can be deteriorated.

### Curing accelerator

The curing accelerator according to the present invention serves to promote curing reaction between the epoxy resin and the acid anhydride curing agent. Specifically, the curing accelerator may include at least one selected from the group consisting of tertiary amines, imidazole compounds, quaternary phosphonium salts, organometallic salts, and phosphorus compounds.

In the quantum dot resin composition, the curing accelerator may be present in an amount of 0.05 parts by weight to 1.0 part by weight, preferably 0.05 parts by weight to 0.5 parts by weight, more preferably 0.08 parts by weight to 0.2 parts by weight. If the content of the curing accelerator is less than 0.05 parts by weight, a sufficient cure acceleration effect cannot be obtained, and if the content of the curing accelerator exceeds 1.0 part by weight, a cured product of the quantum dot resin composition can suffer from discoloration.

### Quantum dots

The quantum dots (QDs) refer to nanoscale semiconductor materials that can have different energy band-gaps depending on the size and composition thereof and thus can emit light at different emission wavelengths.

The quantum dots may have a homogeneous monolayer structure; a multilayer structure, such as a core-shell structure, a gradient structure, and the like; or a mixture thereof. When the shell has a multilayer structure, each layer may contain different components, for example, a (quasi-)metal oxide.

The quantum dots (QDs) may be freely selected from a Group II-VI compound, a Group III-V compound, a Group IV-VI compound, a Group IV element, a Group IV compound, and combinations thereof. If the quantum dots have a core-shell structure, each of the core and the shell may be freely selected from any of the components given by way of example below.

By way of example, the Group II-VI compound may be selected from the group consisting of a binary compound selected from the group consisting of CdO, CdS, CdSe, CdTe, ZnO, ZnS, ZnSe, ZnTe, HgS, HgSe, HgTe, MgSe, MgS, and mixtures thereof; a ternary compound selected from the group consisting of CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and mixtures thereof; and a quaternary compound selected from the group consisting of CdZnSeS, CdZnSeTe, CdZnSTe, CdHgSeS, CdHgSeTe, CdHgSTe, HgZnSeS, HgZnSeTe, HgZnSTe, and mixtures thereof.

In another example, the Group III-V compound may be selected from the group consisting of a binary compound selected from the group consisting of GaN, GaP, GaAs, GaSb, AlN, AlP, AlAs, AlSb, InN, InP, InAs, InSb, and mixtures thereof; a ternary compound selected from the group consisting of GaNPs, GaNAs, GaNSb, GaPAs, GaPSb, AlNPs, AlNAs, AlNSb, AlPAs, AlPSb, InNPs, InNAs, InNSb, InPAs, InPSb, and mixtures thereof; and a quaternary compound selected from the group consisting of GaAlNPs, GaAlNAs, GaAlNSb, GaAlPAs, GaAlPSb, GaInNPs, GaInNAs, GaInNSb, GaInPAs, GaInPSb, InAlNPs, InAlNAs, InAlNSb, InAlPAs, InAlPSb, and mixtures thereof.

In another example, the Group IV-VI compound may be selected from the group consisting of a binary compound selected from the group consisting of SnS, SnSe, SnTe, PbS, PbSe, PbTe, and mixtures thereof; a ternary compound selected from the group consisting of SnSeS, SnSeTe, SnSTe, PbSeS, PbSeTe, PbSTe, SnPbS, SnPbSe, SnPbTe, and mixtures thereof; and a quaternary compound selected from the group consisting of SnPbSSe, SnPbSeTe, SnPbSTe, and mixtures thereof.

In another example, the Group IV element may be selected from the group consisting of Si, Ge, and mixtures thereof. The Group IV compound may be a binary compound selected from the group consisting of SiC, SiGe, and mixtures thereof.

The aforementioned binary, ternary, or quaternary compounds may be present at a uniform concentration in particles, or may be present in the same particle with partially different concentration distributions. In addition, the quantum dots may also have a core/shell structure in which one quantum dot surrounds another quantum dot. An interface between the core and shell may have a concentration gradient in which the concentration of elements in the shell gradually decreases toward the center.

The quantum dots may have any shape without limitation so long as the shape of the quantum dot is commonly used in the art. For example, the quantum dots may have a spherical shape, a rod shape, a pyramidal shape, a disc shape, a multi-armed shape, a cubic nanoparticle shape, a nanotube shape, a nanowire shape, a nanofiber shape, a nano-plate shape, or the like.

Further, the size of the quantum dots is not particularly limited and may be suitably adjusted within the range known to those skilled in the art. For example, the quantum dots may have an average particle diameter (D50) of about 2 nm to about 10 nm. As such, when the average particle diameter of the quantum dots is within the range of about 2 nm to about 10 nm, the quantum dots can emit light of a desired color. For example, when the InP-containing quantum dot core/shell has a particle diameter of about 5 nm to about 6 nm, the quantum dots can emit light having a wavelength of about 520 nm to 550 nm, and when the InP-containing quantum dot core/shell has a particle diameter of about 7 nm to about 8 nm, the quantum dots can emit light having a wavelength of about 620 nm to about 640 nm. For example, non-cadmium (Cd) Group III-V QDs (for example, InP, InGaP, InZnP, GaN, GaAs, and GaP) may be used as blue light-emitting quantum dots (QDs).

As used herein, the quantum dots may include at least one selected from the group consisting of the aforementioned quantum dot nanoparticles, quantum dot-containing particles, primary particles with a plurality of quantum dot particles bonded to each other, and quantum dot composite particles.

In some embodiments, the quantum dot-containing particle may be prepared in the form of a particle containing at least one quantum dot, specifically a particle including at least one quantum dot particle coupled to a surface of an inorganic core particle or a polymer core particle.

In yet another embodiment, the primary particle may be an aggregated particle of a plurality of quantum dots or a particle including a plurality of quantum dots embedded within a matrix. Such a matrix may include an inorganic or organic material known to those skilled in the art.

The primary particle may further include typical heat conductive inorganic particles known to those skilled in the art. The inorganic particles have good thermal conductivity and serve to dissipate heat of the quantum dots to the outside.

The heat conductive inorganic particles may include, for example, aluminum oxide, silicon oxide, titanium dioxide, aluminum nitride, boron nitride, silicon nitride, silicon carbide, aluminum oxide, or mixtures thereof, without being limited thereto.

The average particle diameter of the heat conductive inorganic particles is not particularly limited and may be suitably adjusted within the range known to those skilled in the art. For example, the heat conductive inorganic particles may have an average particle diameter of 1 µm to 100 µm, specifically 1 µm to 50 µm. In some embodiments, a mixture of two or more types of heat conductive inorganic particles having different average particle diameters or different compositions may be used.

The content of the heat conductive inorganic particles is not particularly limited and may be suitably adjusted by taking into account exothermic properties thereof.

In one embodiment, the heat conductive inorganic particles may be present in an amount of 0.1 parts by weight to 99.9 parts by weight, specifically 0.5 parts by weight to 99.5 parts by weight, based on the total weight of the primary particles (for example, 100 parts by weight). Further, the heat conductive inorganic particles may be present in an amount of 1 part by weight to 100,000 parts by weight, specifically 100 parts by weight to 100,000 parts by weight, based on 100 parts by weight of the quantum dots to be mixed therewith.

The quantum dot composite particle may include a surface treatment layer containing at least one of a halide and an oxyhalide between the quantum dot and the polymer coating layer. In a specific example, the quantum dot composite particle may include a quantum dot; an (oxy)halide surface treatment layer bonded to the surface of the quantum dot; and a (meth)acrylic polymer coating layer sequentially formed.

The surface treatment layer may include any halogen (X = F, Cl, Br, I) containing material known to those skilled in the art without limitation and may include, for example, halogen salts of at least one of fluoride, chloride, bromide, and iodide. Specifically, the surface treatment layer may include may include organic halides, inorganic halides, inorganic oxyhalides, or combinations thereof.

The halogen-containing material may include, for example, tetrabutyl ammonium bromide, cetyl trimethyl ammonium bromide, cetyl ammonium bromide (CTAB: cetyl ammonium bromide), ammonium chloride, ammonium bromide, ammonium iodide, ammonium fluoride, potassium chloride, potassium bromide, potassium iodide, sodium chloride, sodium bromide, sodium iodide, sodium fluoride, indium chloride, indium bromide, indium iodide, and the like, without limitation. These may be used alone or in combination thereof.

The polymer may be any acrylic or methacrylic polymer known to those skilled in the art, specifically a (meth)acrylic polymer containing a predetermined range of intramolecular polar functional groups.

In one embodiment, the (meth)acrylic polymer may be a polymer of (meth)acrylic monomers or a (meth)acrylic resin containing at least one polar functional group selected from among a carboxyl group and a hydroxyl group and having a molecular weight (Mw) of 5,000 g/mol or more, specifically 10,000 g/mol to 500,000 g/mol, in which the polar functional group is present in an amount of 1 part by weight or more, specifically 1 part by weight to 50 parts by weight.

For the quantum dots used in the quantum dot resin composition according to the present invention, refer to Korean Patent Laid-open Publication No. 10-2021-0033160 to the extent consistent with this specification.

In the quantum dot resin composition, the quantum dots may be present in an amount of 1 part by weight to 30 parts by weight, preferably 5 parts by weight to 25 parts by weight, more preferably 10 parts by weight to 20 parts by weight. If the content of the quantum dots exceeds 30 parts by weight, the quantum dot resin composition can suffer from deterioration in application properties and optical properties.

### Inorganic fillers

In the present invention, the inorganic fillers may be used together with the epoxy resin and the acid anhydride curing agent to improve mechanical properties of the quantum dot resin composition or a finally cured product, such as reduction in thermal expansion rate and curing shrinkage rate, and adhesion thereof, and to impart thixotropy to the quantum dot resin composition.

In the present invention, the inorganic fillers may be optionally used depending on a required process. Specifically, the inorganic fillers may be used to impart thixotropy to the composition in order to apply the quantum dot resin composition according to the present invention in a dome shape on an LED chip.

The inorganic fillers may include at least one selected from the group consisting of silica, zinc oxide, alumina, calcium carbonate, barium carbonate, barium sulfate, zinc sulfate, zinc sulfide, magnesium oxide, and antimony oxide.

When the inorganic fillers are included in the quantum dot resin composition, the inorganic fillers may be present in an amount of 0.1 parts by weight to 20 parts by weight, 0.1 parts by weight to 15 parts by weight, more preferably 0.1 parts by weight to 10 parts by weight. If the content of inorganic fillers exceeds 20 parts by weight, the quantum dot resin composition can suffer from deterioration in application properties.

### Properties

The quantum dot resin composition according to the present invention has an optical property retention rate of 80% or more, preferably 90% or more, for optical properties of luminance (Lv) and color coordinates (Cx, Cy). The optical property retention rate is calculated by the following Equation 1.Equation 1 Optical property retention rate (%) = (Optical properties of display after operation for 1,000 hours / Optical properties of display before operation) X 100

### Preparation method of quantum dot resin composition

The quantum dot resin composition according to the present invention may be prepared by mixing the epoxy resin, the acid anhydride curing agent, the curing accelerator, and the quantum dots at room temperature. The inorganic fillers may be further mixed therewith to impart thixotropy.

### <Quantum dot resin composite, LED package, and display device>

The present invention provides a quantum dot resin composite prepared by the solvent-free thermosetting quantum dot resin composition described above.

The present invention also provides an LED package that includes an LED chip and a photo-conversion layer formed on the LED chip and prepared by the solvent-free thermosetting quantum dot resin composition described above.

The present invention also provides a display device including the aforementioned LED package.

Next, the present invention will be described in more detail with reference to examples. However, it should be understood that these examples are provided for illustration only and should not be construed in any way as limiting the invention.

### Example 1

A solvent-free thermosetting quantum dot resin composition was prepared by mixing Epoxy resin 1 (EP-4088S, ADEKA), an acid anhydride curing agent (methyl hexahydroanhydride phthalic acid, MH-700G, New Japan Chemical), a curing accelerator (quaternary phosphonium salt), inorganic fillers (SiO₂, EVONIK), and quantum dot composite particles subjected to surface treatment with chloride (according to Example 1 of Korean Patent Laid-open Publication No. 10-2021-0033160). Epoxy resin 1 was a DCPD type epoxy resin that contains a methacrylate functional group. The respective composition ratios are listed in Table 1 below.

### Examples 2 and 3

Solvent-free thermosetting quantum dot resin compositions were prepared in the same manner as in Example 1 excluding the content of Epoxy resin 1 and the content of the acid anhydride curing agent.

### Examples 4 and 5

Solvent-free thermosetting quantum dot resin compositions were prepared in the same manner as in Example 1 except that Epoxy resin 1 and epoxy resin 2 (TGIC, TEPIC-S, Nissan Chemical) were mixed in different composition ratios.

### Comparative Examples 1 and 2

Solvent-free thermosetting quantum dot resin compositions were prepared in the same manner as in Example 1 except that Epoxy resin 2 and Epoxy resin 3 (C-2021P, Daicel Corporation) were mixed in different composition ratios. Epoxy resin 3 was 3,4-epoxycyclohexylmethyl 3,4-epoxycyclohexanecarboxylate, which is an alicyclic epoxy.

**Table 1**

| Unit: wt% | Example 1 | Example 2 | Example 3 | Example 4 | Example 5 | Comparative Example 1 | Comparative Example 2 |
|---|---|---|---|---|---|---|---|
| Epoxy resin 1 | 41.5 | 46.0 | 37.5 | 29.0 | 34.0 | - | - |
| Epoxy resin 2 | - | - | - | 9.5 | 5.0 | - | 17.0 |
| Epoxy resin 3 | - | - | - | - | - | 40 | 17.0 |
| Acid anhydride curing agent | 39.0 | 34.5 | 43.0 | 42.0 | 41.5 | 40.5 | 46.5 |
| Curing accelerator | 0.1 | 0.1 | 0.1 | 0.1 | 0.1 | 0.1 | 0.1 |
| Quantum dot composite | 14.4 | 14.4 | 14.4 | 14.4 | 14.4 | 14.4 | 14.4 |
| Inorganic filler | 5.0 | 5.0 | 5.0 | 5.0 | 5.0 | 5.0 | 5.0 |
| Total | 100.0 | 100.0 | 100.0 | 100.0 | 100.0 | 100.0 | 100.0 |

### <Evaluation of optical property (Lv, Cx, Cy) retention rate>

Each of the quantum dot resin compositions prepared in Examples 1 to 5 and Comparative Examples 1 and 2 was applied to an LED chip on a PCB substrate and cured at about 190°C for about 5 minutes to manufacture a display device. Initial optical property values (Lv, Cx, Cy) before operation of the display device and optical property values after operation of the display device for 1,000 hours were measured using an optical property measurement device (CA410), and the optical property retention rate was calculated according to Equation 1. The results are shown in Table 2.Equation 1 Optical property retention rate (%) = (Optical properties of display after operation for 1,000 hours / Optical properties of display before operation) X 100

**Table 2**

| | | Example 1 | Example 2 | Example 3 | Example 4 | Example 5 | Comparative Example 1 | Comparative Example 2 |
|---|---|---|---|---|---|---|---|---|
| Lv | Initial (%) | 100.0 | 100.0 | 100.0 | 100.0 | 100.0 | 100.0 | 100.0 |
| | Retention rate (%) after 100 hours | 99.8 | 99.7 | 99.4 | 88.8 | 86 | 55.2 | 64.7 |
| Cx | Initial (%) | 100.0 | 100.0 | 100.0 | 100.0 | 100.0 | 100.0 | 100.0 |
| | Retention rate (%) after 100 hours | 92.1 | 91.5 | 90.8 | 89.9 | 88.5 | 80.7 | 87.3 |
| Cy | Initial (%) | 100.0 | 100.0 | 100.0 | 100.0 | 100.0 | 100.0 | 100.0 |
| | Retention rate (%) after 100 hours | 91.2 | 90.8 | 90.2 | 81.7 | 86.3 | 64.6 | 70.9 |

Comparing Examples 1 to 5 with Comparative Examples, it could be seen that Comparative Examples had poorer optical property retention rates than Examples 1 to 5 for all optical properties (Lv, Cx, and Cy), especially for Lv and Cy. On the other hand, it could be seen that Examples 1 to 5 had retention rates of 80% or more for all items and most examples had good retention rates of 90% or more.

In Examples 1 to 5, the higher the content of DCPD type epoxy resin, the better the optical property retention rate and the compositions using only the DCPD type epoxy resin as in Examples 1 to 3 had Lv retention rates of 99% or more.

In Examples 1 to 3, when the weight ratio of the epoxy resin to the curing agent was about 1:0.94 (Example 1), the quantum dot resin composition exhibited better retention rates for all items.

It should be understood that the present invention is not limited to the above embodiments and various modifications, changes, alterations, and equivalent embodiments can be made by those skilled in the art without departing from the spirit and scope of the invention.

## Claims

1. A solvent-free thermosetting quantum dot resin composition comprising: quantum dots; an epoxy resin; an acid anhydride curing agent; and a curing accelerator,
wherein the epoxy resin comprises a dicyclopentadiene type epoxy resin.

2. The solvent-free thermosetting quantum dot resin composition according to claim 1, wherein the epoxy resin further comprises triglycidyl isocyanurate.

3. The solvent-free thermosetting quantum dot resin composition according to claim 1, wherein the dicyclopentadiene type epoxy resin contains a (meth)acrylate functional group.

4. The solvent-free thermosetting quantum dot resin composition according to claim 1, wherein the epoxy resin and the acid anhydride curing agent are comprised in a weight ratio of 1:0.5 to 1:1.4.

5. The solvent-free thermosetting quantum dot resin composition according to claim 1, wherein the solvent-free thermosetting quantum dot resin composition has an optical property retention rate of 80% or more, as calculated by Equation 1. [Equation 1] Optical property retention rate (%) = (Optical properties of display after operation for 1,000 hours / Optical properties of display before operation) X 100

6. The solvent-free thermosetting quantum dot resin composition according to claim 1, comprising:
1 part by weight to 30 parts by weight of the quantum dots;
1 part by weight to 50 parts by weight of the epoxy resin;
1 part by weight to 50 parts by weight of the acid anhydride curing agent; and
0.05 parts by weight to 1 part by weight of the curing accelerator.

7. The solvent-free thermosetting quantum dot resin composition according to claim 1, wherein the epoxy resin further comprises at least one selected from the group consisting of an alicyclic epoxy resin, a BPA-PO epoxy resin, a bisphenol A type resin, a bisphenol F type epoxy resin, a novolac type epoxy resin, a nitrogen-containing epoxy resin, a linear aliphatic epoxy resin, and a naphthalene type epoxy resin.

8. The solvent-free thermosetting quantum dot resin composition according to claim 1, wherein the acid anhydride curing agent comprises at least one selected from the group consisting of phthalic anhydride, maleic anhydride, trimellitic anhydride, hexahydrophthalic anhydride, tetrahydrophthalic anhydride, methyl nadic anhydride, nadic anhydride, glutaric anhydride, dimethyl glutaric anhydride, diethyl glutaric anhydride, methyl hexahydrophthalic anhydride, and methyl tetrahydrophthalic anhydride.

9. The solvent-free thermosetting quantum dot resin composition according to claim 1, wherein the curing accelerator comprises at least one from the group consisting of tertiary amines, imidazole compounds, quaternary phosphonium salts, organometallic salts, and phosphorus compounds.

10. The solvent-free thermosetting quantum dot resin composition according to claim 1, further comprising: inorganic fillers,
the inorganic fillers comprising at least one selected from the group consisting of silica, zinc oxide, alumina, calcium carbonate, barium carbonate, barium sulfate, zinc sulfate, zinc sulfide, magnesium oxide, and antimony oxide.

11. A quantum dot resin composite prepared by the solvent-free thermosetting quantum dot resin composite according to any one of claims 1 to 10.

12. An LED package comprising:
an LED chip; and
a photo-conversion layer formed on the LED chip and prepared by the solvent-free thermosetting quantum dot resin composition according to any one of claims 1 to 10.

13. A display device comprising the LED package according to claim 12.
